Europäisches Patentamt

European Patent Office

Office européen des brevets

(19)

(11) **EP 1 317 035 A1**

(12) **EUROPEAN PATENT APPLICATION**

(43) Date of publication:
**04.06.2003 Bulletin 2003/23**

(51) Int Cl.7: **H01S 5/183**, H01S 5/42,
H01S 5/065

(21) Application number: **01310006.0**

(22) Date of filing: **29.11.2001**

| | |
|---|---|
| (84) Designated Contracting States:<br>**AT BE CH CY DE DK ES FI FR GB GR IE IT LI LU MC NL PT SE TR**<br>Designated Extension States:<br>**AL LT LV MK RO SI**<br><br>(71) Applicant: **Hitachi Ltd.**<br>**Tokyo 101-10 (JP)**<br><br>(72) Inventors:<br> • **Heberle, Albert P.**<br>  **Coton, Cambridge CB3 7PX (GB)** | • **Gordon, Reuven**<br>  **Cambridge CB3 0DS (GB)**<br> • **Tanaka, Toshiaki**<br>  **Girton, Cambridge CB3 0NW (GB)**<br><br>(74) Representative: **Read, Matthew Charles et al**<br>**Venner Shipley & Co.**<br>**20 Little Britain**<br>**London EC1A 7DH (GB)** |

(54) **Optical pulse generator**

(57)     An optical pulse generator comprises a vertical cavity semiconductor laser (19) is operable with transverse mode locking and has an output port configuration (28) to receive light emitted in only a part of its cavity (8) whereby to produce a pulsed optical output (A).

FIG. 3

**EP 1 317 035 A1**

**Description**

This invention relates to an optical pulse generator for producing pulses with a high repetition rate and has particular but not exclusive application to fibre optic telecommunication systems with all optical signal processing.

Fibre optic telecommunication systems with all optical signal processing e.g. OTDM have been proposed which utilise optical pulse picosecond or femtosecond sources with a high repetition rate of e.g. >40GHz. In order to provide reliable and flexible signal processing with a low bit-error rate, the pulse sources need to operate with low timing jitter and good tunability of their pulse repetition rate.

At present, the following pulse sources are available: mode locked edge emitting semiconductor lasers, gain switched semiconductor lasers and self-pulsating lasers. However, only mode-locking produces sufficiently high pulse repetition rates with picosecond or femtosecond pulses. Monolithic semiconductor mode-locked laser have been demonstrated but they require a high injection current and have high jitter due to spontaneous emission noise as described in D.J. Derickson, P.A. Morton and J.E. Bowers, Applied Physics Letters 59, 3372 (1991). Furthermore, the production of arrays of such lasers is difficult and two dimensional arrays cannot be processed monolithically.

It is known that vertical cavity surface emitting lasers (VCSELs) are compact, efficient and can be readily fabricated in arrays. A practical example of a VCSEL is described in US Patent 6 061 381. VCSELs are fabricated in overlying layers on a substrate so as to provide first and second reflective elements, typically Bragg reflectors, spaced apart by relatively small thickness dimension, the arrangement giving rise to an a optical resonant cavity that has a relatively large dimension in a direction transverse to the thickness dimension. In a conventional VCSEL, the cavity resonates with a single longitudinal mode so that light is generated and transmitted out of the cavity transversely. The cavity contains a layer of laser active material, which can be stimulated either electrically or pumped optically. However, the longitudinal mode of the VSCEL cannot readily be subjected to mode locking in the manner of a conventional edge imaging laser.

Self-pulsation of VSCELs and also multi-mode operation is known, as described in "Pinning of Daisy Modes in Optically Pumped Vertical-Cavity Surface Emitting Lasers" S.F. Pereiear et al Appl. Phys. Lett. Vol. 73, No. 16, 19 October 1988 pp 2239-2241, in which daisy modes attributed to Laguerre Gauss (LG) transverse modes are described.

It is also known that the transverse modes can be produced in the VSCEL by electrical pumping, as described in "Transverse mode emission characteristics of gain-guided surface emitting lasers" K. Tai et al Appl. Phys. Lett. Vol. 63 No. 19, 8 November 1993 p.p. 2624-2626.

An object of the present invention is to achieve mode locking of transverse modes that may be utilised for example in a vertical cavity laser so as to achieve pulse generation.

According to the invention from one aspect there is provided an optical pulse generator comprising first and second reflective elements spaced apart by a relatively small thickness dimension to provide an optical resonant cavity that has a relatively large dimension in a direction transverse to the thickness dimension, the cavity being configured to resonate in a plurality of transverse modes which interact to produce mode locking whereby pulsed optical radiation is produced in transversely disposed regions of the cavity, and an optical port configuration to provide an output that comprises pulsed optical radiation emitted transversely of the cavity from one of the regions individually.

The cavity may include laser active material for producing optical radiation that is reflected in a plurality of modes between the first and the second reflective elements for mode locked laser operation. The cavity may be pumped by a pumping arrangement into optical resonance. Where the pumping arrangement is electrically driven, it may comprise electrodes for applying and energising current to the laser active material to produce optical resonance in the plurality of transverse modes to as to produce the mode locking.

The cavity may contain a material having an optical refractive index that is a function of the applied current through Joule heating and carrier density changes, and the electrodes may be configured to apply a non-uniform electrical current distribution to the cavity so as to produce optical resonance in the plurality of transverse modes.

Where the pumping arrangement is optically driven, a laser may be used to deliver pumping radiation into the cavity.

A modulator may be provided to modulate optical resonance in the cavity and promote mode locking actively. The modulator may be operable electrically to apply a modulating current to the cavity, or may be operable optically by applying modulating optical radiation to the cavity.

At least one absorptive region may be arranged to absorb selectively the resonant optical radiation from the cavity so as to promote the mode locking.

The optical port configuration may comprise an optical imaging system that images optical radiation from one of the cavity regions onto a predetermined focus region. An electrical detector may be disposed as the focus region to produce electrical pulses corresponding to the pulsed optical radiation.

The optical pulse generator may utilise a VCSEL, and, in another aspect, the invention provides an optical pulse generator comprising a vertical cavity semiconductor laser operable with transverse mode locking and characterised by an output port configuration to receive light emitted in only a part of the cavity whereby to produce a pulsed optical output.

In order that the invention may be more fully understood embodiments thereof will now be described by way of example with reference to the accompanying drawings in which:

Figure 1 is a schematic illustration of conventional mode locking techniques;

Figure 2 is a top plan view of a VCSEL for use in the invention;

Figure 3 is a sectional view of the device of Figure 2 taken along line X - X';

Figure 4 is a plan view of transverse Laguerre-Gauss modes produced during operation of the device;

Figure 5 illustrates the VCSEL with an output port configuration;

Figure 6 is a schematic illustration of the VCSEL with an alternative output port configuration;

Figure 7 illustrates the VCSEL with a diffractive optical arrangement for focussing its pulsed optical output onto a photodetector;

Figure 8 is a schematic illustration of the VCSEL with an optical waveguide output;

Figure 9 corresponds to Figure 8, with a multiple waveguide output configuration;

Figure 10 illustrates a mode locked VCSEL with a monolithically formed photodetector;

Figure 11 illustrates the VCSEL with multiple modulators and detectors integrally formed;

Figure 12A is a schematic top plan view of the VCSEL illustrating its output port configuration, with a single output port;

Figures 12B and 12C illustrate multiple output port configurations;

Figure 13A is a sectional view of Figure 12A;

Figure 13B, C and D illustrate different modifications of the configuration of Figure 13A;

Figure 14 is a top plan view of a VCSEL with an alternative, centrally disposed contact and ion implantation region;

Figure 15A is a cross sectional view of the arrangement of Figure 14;

Figure 15B and 15C illustrate modifications to the arrangement of Figure 15A;

Figure 16 is a sectional view of a VCSEL that includes a saturable absorber;

Figure 17 is a sectional view of a VCSEL with an alternative saturable absorber configuration;

Figure 18 is a sectional view of a VCSEL with a saturable absorber that extends around the perimeter of the optical cavity;

Figure 19 illustrates the top electrical contact, configured as modulation electrodes;

Figure 20 is an alternative configuration to that shown in Figure 19;

Figure 21 illustrates optical pumping of the VCSEL schematically;

Figure 22 is a more practical example of an electrically pumped VCSEL which optically pumps an overlying mode locked VCSEL, formed as a monolithic structure;

Figure 23 is a cross sectional view of a VCSEL with an integrated modulator for modulating its optical output;

Figure 24 is a sectional view of a VCSEL with an output contact for producing a clock output;

Figure 25 is a schematic top plan view of a schematic cavity arrangement for controlling the phase of output pulses from the laser;

Figure 26 is a schematic top plan view of a rectangular cavity for the laser;

Figure 27 is a top plan view of an alternative laser structure which utilises lateral oxidisation to provide a cavity confinement layer;

Figure 28 is a cross sectional view of the device show in Figure 27; and

Figure 29 illustrates the pulsed optical output produced by an optical pulse generator in accordance with the invention.

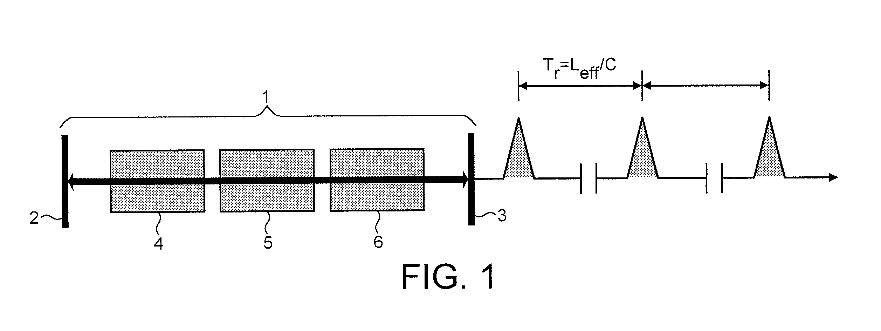

Mode-locking of lasers can produce picosecond or femtosecond pulses with a high repetition rate, in excess of 40GHz. Figure 1 illustrates the basic arrangement of a typical mode-locked laser with a linear resonator i.e. as used in a convention edge imaging semiconductor mode-locked laser. The laser includes a cavity 1 between first and second mirrors 2, 3. The cavity contains an active medium 4 which produces an optical gain together with a modulator 5. A dispersion compensator 6 may also be included. The cavity 1 supports multiple longitudinal resonant modes.

The laser produces a chain of pulses separated by the cavity round-trip time:

$$T_r = L_{eff}/c.$$

where

$$L_{eff} = \sum_i L_i / n_i$$

is the sum of the effective optical paths $L_i n_i$ that the light has to travel during one round trip, n; being the respective refractive indices.

The modulator 5 modulates the resonant cavity at the round trip frequency $f_r = 1/T_r$. The modulator 5 thus phase-locks the longitudinal modes of the laser as a result, induces short pulses due to interference of the longitudinal modes. The longitudinal modes have a nearly constant node spacing defined by $f_r$. Any deviation from the constant mode spacing induces dispersion and this can be compensated by the dispersion compensator 6, which enforces constant mode spacing.

The modulator 5 can induce intensity and phase modulation due to light induced nonlinearity i.e. passive mode-locking or by the use of externally driven modulation at a frequency $f_r$ i.e. active mode locking, or external modulation at some harmonic of $f_r = f_r/N$, where N is a positive integer. However, this conventional approach to longitudinal mode-locking cannot be applied to lasers with one single longitudinal mode such as a VCSEL.

In accordance with the invention, a different approach is taken. Lateral modes of a laser VCSEL are mode locked. A series of lateral modes with equidistant frequency spacing $f_r$ are created and mode locked either actively or passively. If the modes are not completely equidistant, dispersion will occur, as in the case of longitudinal mode locking just described, and a dispersion compensator may be utilised to correct the dispersion and maintain the mode locking.

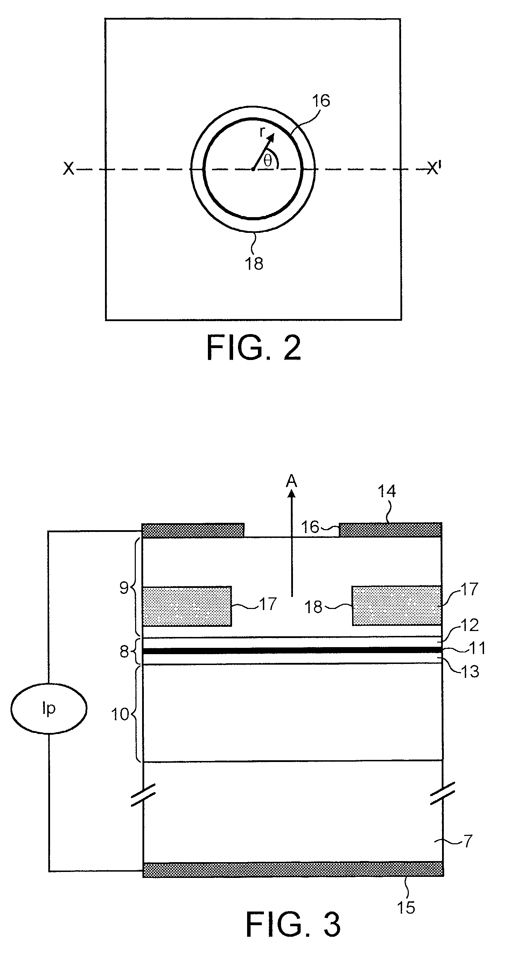

An example of lateral mode locking in a vertical cavity laser will now be described . Referring to Figures 2 and 3, a VSCEL is shown that comprises a substrate 7 on which a resonant cavity 8 is formed between overlying and underlying Bragg reflectors 9, 10. The cavity includes laser active material in a layer 11, disposed between spacer layers 12, 13. The substrate is typically formed of $SiO_2$. Each of the Bragg reflectors 9, 10 may comprise multiple layer structure, comprising overlying layers of materials with differing refractive index, with a thickness typically of $\lambda/4n$ where $\lambda$ is the wavelength of operation of the laser. The cavity 8 typically has a thickness of $3\lambda/2$. The wavelength $\lambda$ may be 1550nm for telecommunications, and suitable materials and layer thicknesses for a VSCEL operable at this wavelength are specified in "In GaAs Vertical Cavity Surface-Emitting Lasers, R. S. Geels, S. W. Corzine and L. A. Coldren, IEEE Journal of Quantum Electronics, Vol 27, No. 6, 6 June 1991, pp 1359-1367 which can be used in the device according to the invention. Briefly stated, the Bragg reflector layers 9, 10 may comprise overlying quarter-wave layers of AlAs-GaAs with 18.5 mirror periods, with a graded Al content across the mirror thickness. The laser active material 11 within the cavity 8 may comprise 80Å $In_{0.2}GA_{0.8}As$ quantum wells and the spacer layers 12, 13 may comprises $Al_{0.2}Ga_{0.8}As$ of a suitable thickness to achieve the aforementioned $3\lambda/2$ resonant condition at 1550nm.

The laser may also be configured for operation in a communications window around 1300nm or in the 800-100nm band.

The laser active material 11 may comprise a variety of materials depending on the wavelength for operation. For shorter wavelengths AlGaAs, GaP, InGaP or GaAsP can be used. GaAs can be used at 850nm. For 1550nm, InGaAs or InGaAsP can be used. The quantum wells are typically 8-12nm in dimension.

The laser is provided with top and bottom electrical contacts 14, 15, which may comprise metalisation layers. The top contact 14 includes a circular aperture 16 of a diameter of the order of 20μm. In use, an electrical current $I_p$ is passed through the device between the contacts 14, 15, which pumps the cavity 8 and stimulates optical emission in the laser active material 11 so that light is emitted from the cavity in the direction of arrow A shown in Figure 3.

An annular ion implanted region 17 is provided to provide lateral current confinement i.e. to force the current flowing between top and bottom contacts 14, 15 through the central region of the cavity. The ion implanted region 17 also controls the lateral gain across the cavity. The ion implanted region 17 thus has a central aperture 18 of generally similar diameter to the aperture 16 in the upper contact 14. The arrangement results in a concentration of current near the edges of aperture 18 which induces increased optical gain in the cavity 8 near the edges of aperture 18 together with an inhomogeneous temperature profile. This temperature profile leads to a parabolic refractive index profile in the radial direction r shown in Figure 2.

$$n(r) = n_o - \frac{a^2}{2n_o}r^2$$

The resulting gain and refractive index distribution allows for Laguerre-Gauss (LG modes) with radial index $p=0$ and azimuthal index $l = 1,2,3....$ These modes form a ring around the edge of the aperture 18, with $l$ maxima in the azimuthal direction. The intensity distribution of these modes is given by:

$$I(r,\theta) = \frac{4}{l!}\frac{1}{w^2}\left(\frac{2r^2}{w}\right)^l \exp\left(-2r^2/w^2\right)\frac{1}{\pi}\cos^2(l\theta).$$

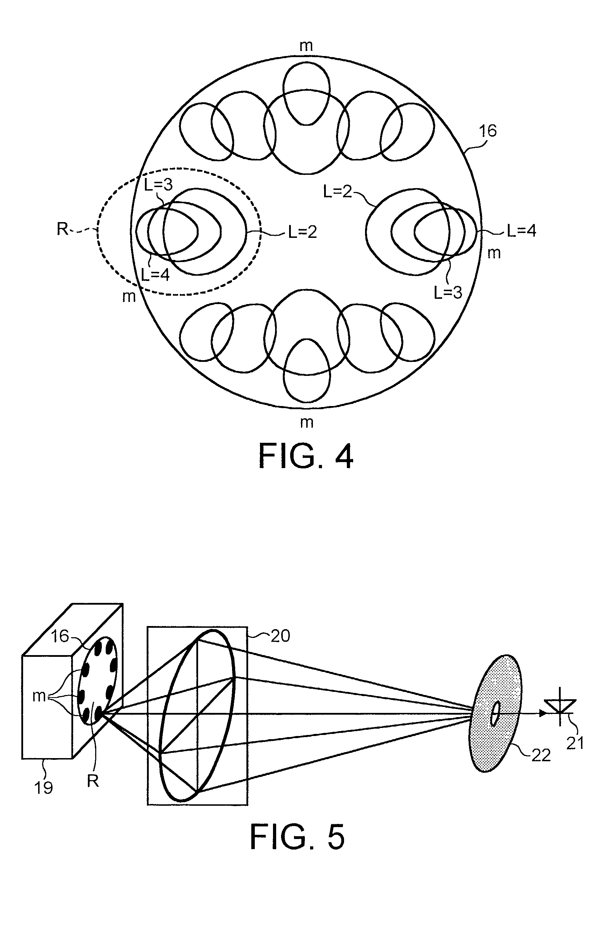

Figure 4 illustrates a set of such transverse modes with $l$=2, 3, 4. The contours illustrate the shape of the different modes at half the maximum of intensity distribution. The parabolic variation of refractive index within the cavity as a function of radius, is only necessary in the part of the aperture with the most mode intensity. Other refractive index patterns may be designed to obtain equal mode spacing.

The frequency separation between the LG modes is constant, namely:

$$\Delta f = \frac{ca}{2\pi n_0^2}$$

where

    c is the speed of light

    a is a characteristic diameter radius of the refractive index profile, and

    $n_0$ is the constant background refractive index.

The ion implanted region 17 acts as a saturable absorber and in combination with the reduced current in the centralmost region of the aperture 16, achieves the desired mode locking of the lateral LG modes shown in Figure 4. However, as explained hereinafter, specifically designed modulation and absorption elements may be utilised to promote the mode locking a more predictable manner.

When an output is taken from the region R shown in Figure 4, the mode locking results in a pulsed output with a pulse frequency $f_r = \Delta f$. It will be understood that when light is taken from the entire aperture area shown in Figure 4, the various modes average out and so no pulsation is observed. However, in the region R, the mode locking results in the desired pulsed output.

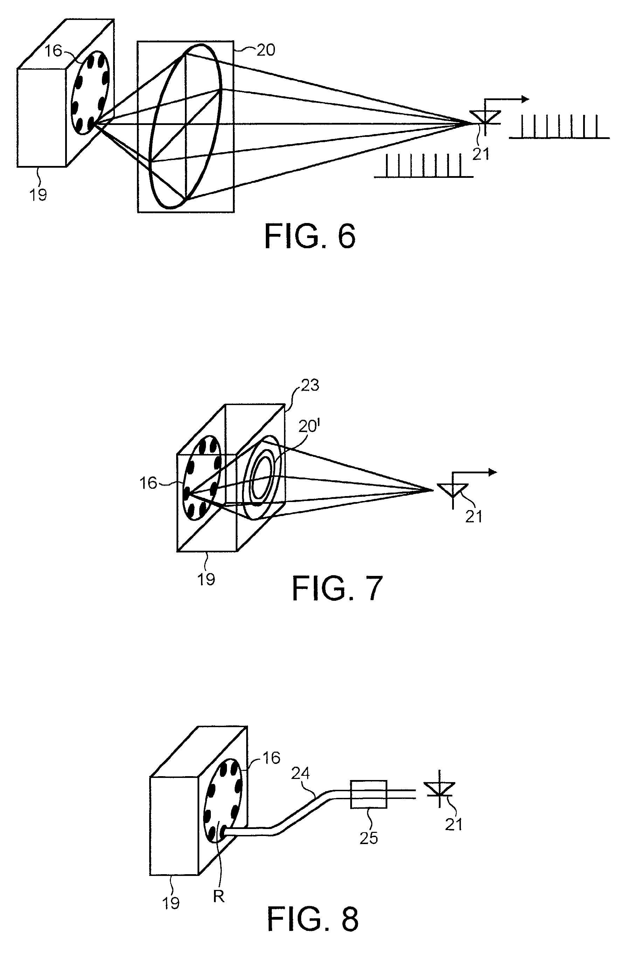

Figure 5 illustrates a schematic arrangement for detecting the optical pulses from region R. The VCSEL of Figures 2 and 3 is referenced 19 with output aperture 16 has a series of radially distributed mode maxima $m$ as shown in detail in Figure 4. Optical radiation from one of the maxima, in the region R, is imaged by means of an imaging system 20 onto a detector 21 through a spatial filter 22. The imaging system 20 may comprise a lens, mirror or detractive optics and the spatial filter 22 may comprise an aperture. Alternatively, as shown in Figure 6, the spatial filter may be omitted so that the detector can be mounted sufficiently close to the output aperture 16, for example in a monolithic structure.

Another modification is shown in Figure 7 in which rear face 23 of VCSEL 19 is provided with a Fresnel lens with an asymmetric arrangement of Fresnel elements 20', configured so that light emitted from region R is selectively focussed onto detector 21, which is disposed to the rear of the laser 19.

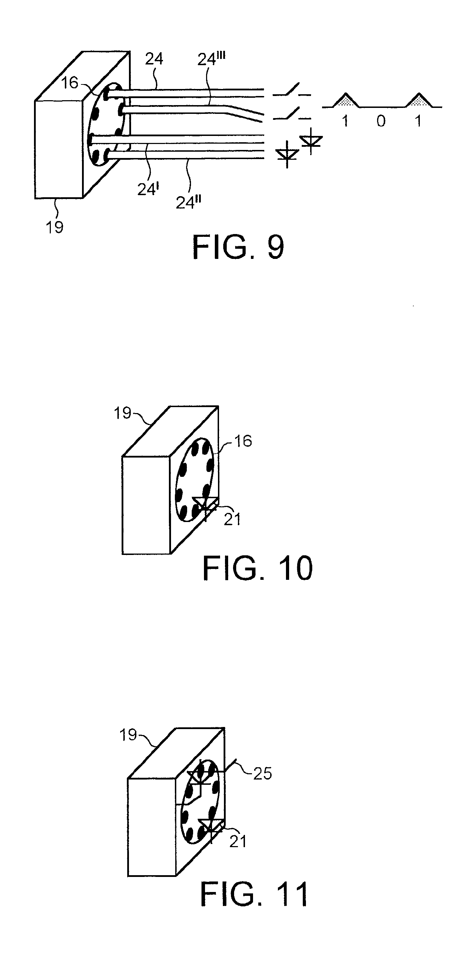

As shown in Figure 8, a waveguide 24 may be used to guide light from region R to the detector 21. The waveguide 24 may include an optical modulator 25 so that packets of the pulsed optical radiation from region R can be produced. Referring again to Figure 4, it will be seen that there are a plurality of regions R which can be used to provide pulsed optical radiation and, as shown in Figure 9, individual optical waveguides 24, 24', 24", 24''' are provided to obtain pulsed optical outputs from the individual regions respectively. The optical waveguides 24 may comprise optical fibres and may be connected to individual detectors or modulators in the manner shown in Figure 8. The pulsed optical radiation produced at the individual regions of the output aperture 16 have a predetermined phase relationship to one another and so a coherent phase relationship is provided between the pulses that are distributed through waveguides 24.

In the embodiments of Figures 10 and 11, one or more detector 21 and/or one or more modulator 25 may be directly mounted on the VCSEL 19 to provide a monolithic structure.

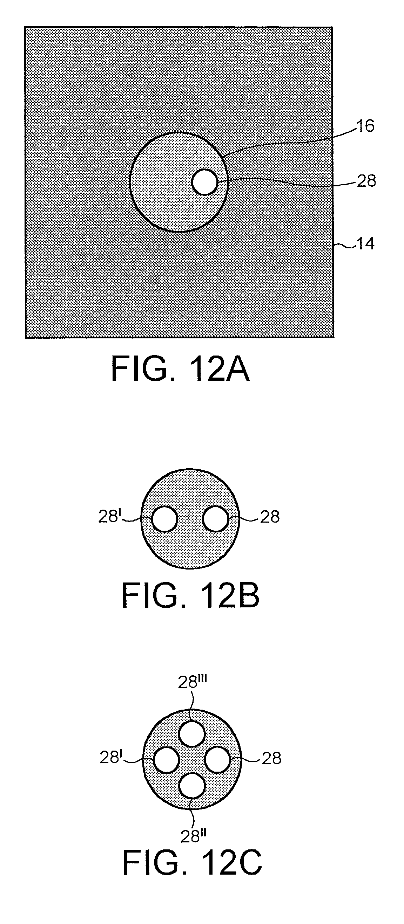

Referring to Figure 12A, it is advantageous to arrange an output port aperture 28 coextensive for the region R at an appropriate radial position relative to aperture 16 so that pulsed optical radiation is emitted selectively through the output port aperture. It will be understood that if more than one output is required, for example as shown in Figures 9 or 11, aperture arrangements as shown in Figure 12B (two output ports) or 12C (four output ports) may be provided. This can be achieved in a number of different ways.

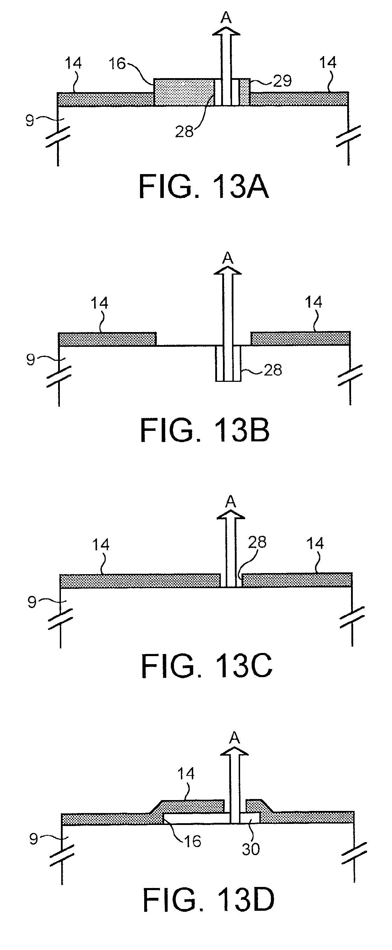

Referring to Figure 13A, an additional Bragg reflector 29 is formed overlying the aperture 16. The output port aperture 28 may be formed in layer 29 by selective interdiffusion of the Bragg reflector layers in order to provide a transparent region that selects radiation from the region R. Alternatively, an absorptive layer can be used instead of the Bragg reflector 29. If a Bragg reflector or e.g. a metalisation layer is used as a reflective element, the phase of the reflected light should preferably constructively add to the resonance of the cavity.

Alternatively, as shown in Figure 13B, the output port 28 can be formed by interdiffusion of the top Bragg reflector 9, in which case the number of periods of the Bragg reflector 9 can be increased in order to reduce light emission except for in the region of output port aperture 28. In another arrangement shown in Figure 13C, the electrode 14 extends over the aperture 16 except in the region of output port 28. In this situation it may be advantageous to include an intermediate layer 30 to avoid the electrodes 14 contacting the aperture 16. The intermediate layer 30 may comprise a half wave layer or stack. It will be understood that the alternative structures of 13A - D may be used in combination in certain circumstances to improve device performance.

The lateral refractive index profile of the cavity and the gain distribution for laser active layer 11, have a strong influence of the mode distributions and the mode energies. Changing the mode energies by altering the injection bias i.e. the current supplied through the cavity between electrodes 14, 15, can change the repetition rate of the pulses produced by the laser 19 during operation.

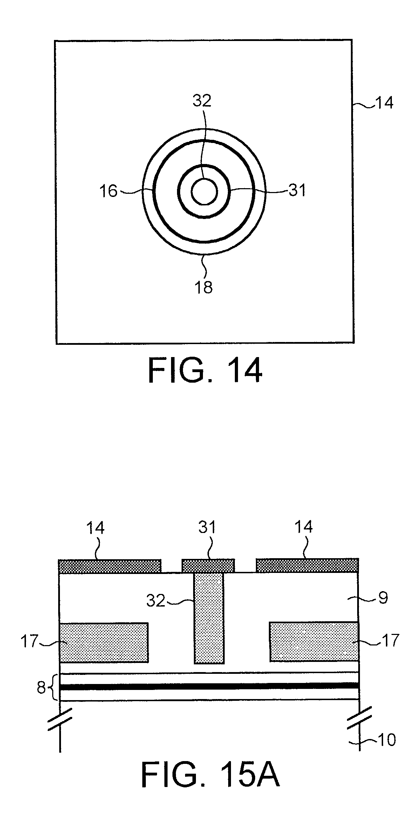

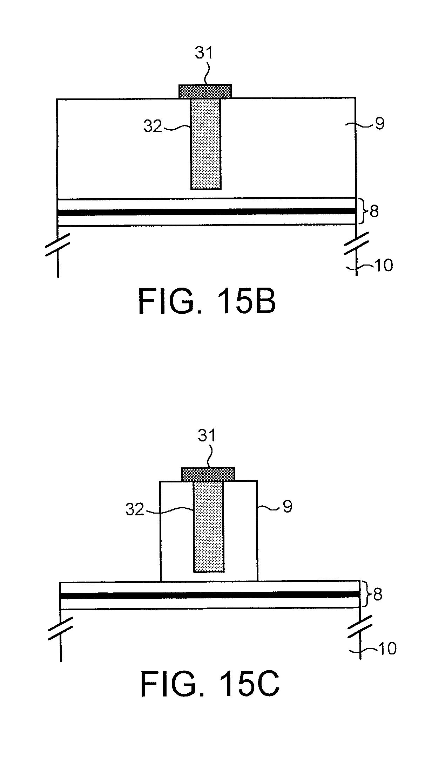

Referring to Figure 14 and Figure 15A an additional central contact 31 is provided, coupled to an associated central ion implanted region 32. The dopants may comprise $H^+$, $O^+$ $N^+$ or $F^+$ ions. The contact 31 thus permits an individual bias to be applied centrally so as to provide further control on the current distribution within the device to allow effective control of mode locking. In an alternative shown in Figure 15B, top contact 14 and the ion implanted region 17 are omitted so that current is applied solely through contact 31 which, together with ion implanted region 32 provides sufficient control of the current distribution to achieve the desired mode locking. In a further modification shown in Figure 15C, a mesa etch is performed through the top Bragg reflector 9 to produce a current confinement region, so as to control the current distribution within the cavity 8.

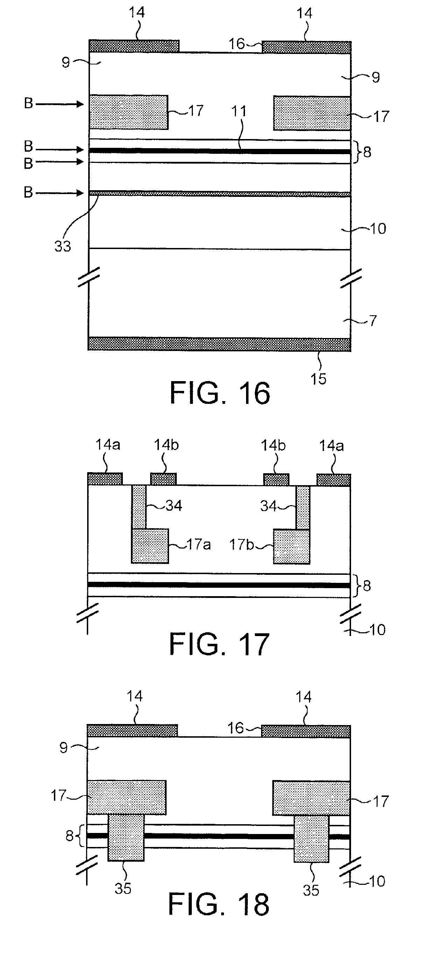

Referring to Figure 16, the mode locking can be enhanced by the inclusion of a saturable absorber. In Figure 16, the saturable absorber comprises one or more layers 33, which may comprise quantum wells or bulk layers that exhibit optical absorption of the laser emission produced by the device, for example quantum wells with larger well widths or smaller band gaps than the layers of the laser active region 11. Arrows B indicate suitable position for inclusion of one or more layers 33 in the device. The strength of the absorption can thus be adjusted since the optical field strength varies as a function of vertical position in the cavity. The saturable absorbing layers 33 when disposed in the Bragg reflectors will avoid recombination loss since the reflectors contain only one type of carriers, either holes or electrons.

An alternative saturable absorber configuration is shown in Figure 17. In this arrangement, a reverse bias is applied to the outer perimeter of the active region to produce absorption. To this end, the top contact 14 is fabricated as concentric rings 14a, 14b which are reverse biased and forward biased respectively. The ion implanted region 17 is formed as concentric ring 17a and an ion implanted region 34 extends from the region 17a between the contact rings 14a, 14b, so as to provide an isolating wall which guides current from the forward biased ring 14b thought the cavity 8. The wall 34 can alternatively be formed by trench etching (not shown).

In a further alternative shown in Figure 18, a circular region 35 is subject to ion implantation so as to introduce damage into the cavity region 8 and provide saturable absorption. Instead of ion implantation, trench etching or mesa etching could be utilised.

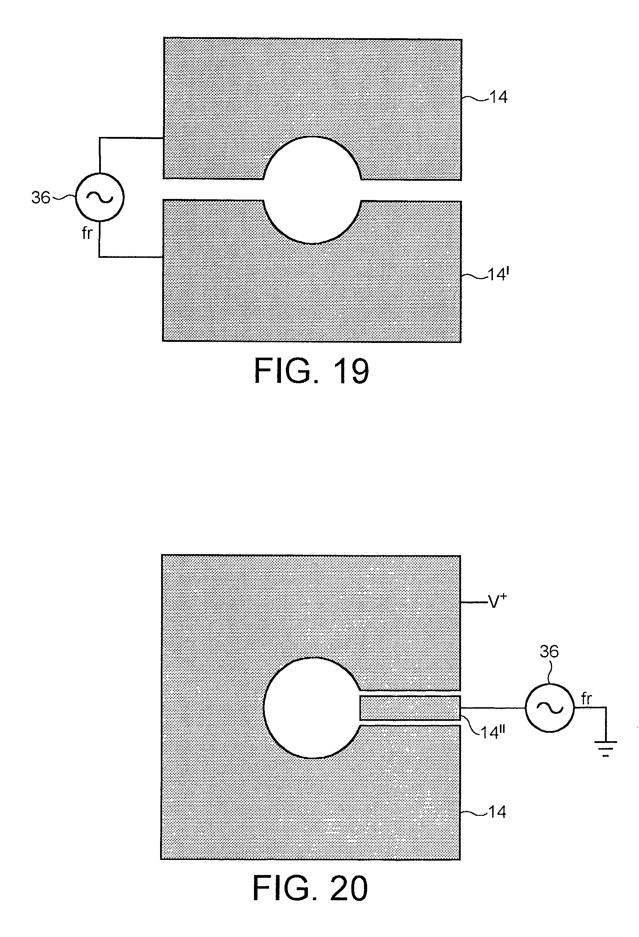

Referring to Figure 19, a modulator may be used to mode lock the VCSEL actively.

The top contact 14 is configured as two electrodes 14, 14' which, in addition to receiving the bias current $I_p$ shown in Figure 3, additionally receive a modulating current from a modulation source 36 at frequency $f_r$. Preferably, a simple $\pi$ phase shift between the two electrodes is provided. In the arrangement of Figure 19, two electrodes are provided but it would be possible to utilise more than two, in which case the phase shift between the electrodes is modified accordingly.

An alternative configuration is shown in Figure 20 in which modulation electrode 14" is configured to be significantly smaller than the main bias electrode 14 so as to reduce the required modulation power and also the electrode capacity. It would be possible to include more than one such modulation electrode. The modulation produced by modulation source 36 modulates the carrier density and refractive index within the device which leads to locking of the transverse modes.

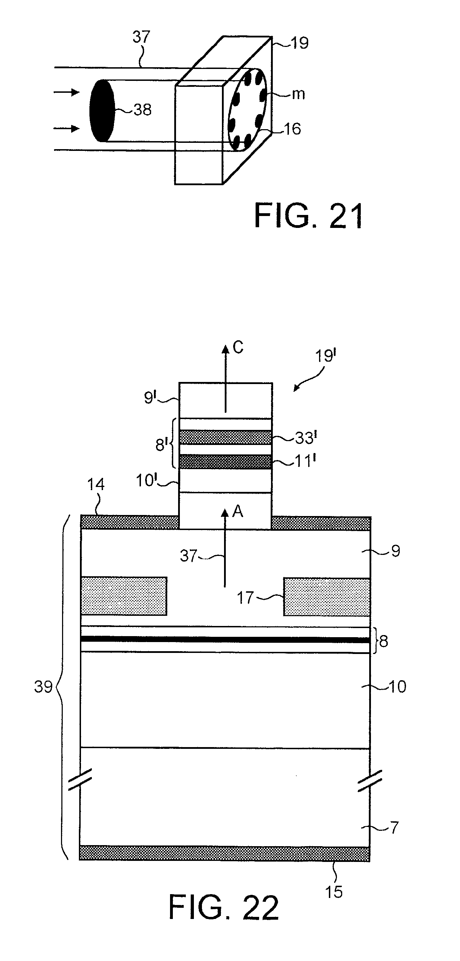

In the embodiments of the invention described so far, the VCSEL is pumped electrically by means of a bias current $I_p$ applied between the top and bottom electrodes 14, 15. However, the laser can be pumped optically and the optical pumping can be used to modulate the optical resonance in order to achieve lateral mode locking. Figure 21 schematically illustrates optical pumping of VCSEL 19 with a pump beam 37 optical radiation. It will be understood that the optical pumping can be used instead of or in addition to the previously described electrical pumping. An optical element 38 may be included in order to shape the intensity distribution of the optical beam 37 applied to the cavity of the laser 19, so as to provide an intensity distribution which promotes the phase-locked lateral modes.

A more practical arrangement is shown in Figure 22, in which a first VCSEL 39 having the same structure as described with reference to Figure 3, is electrically pumped between its top contact and bottom contact 14, 15 in order to produce a laser pumping beam 37 in the direction of arrow A. The second VCSEL 19' is fabricated to overlie the laser 39. The laser 19' comprises a cavity 8' disposed between top and bottom Bragg reflectors 9', 10'. The cavity 8' includes a laser active layer 11' together with an optional saturable absorber layer 33'. In use, the laser emission 37 from laser 39 pumps the laser 19' driven into resonance with lateral mode-locking such that a pulsed laser output C is produced. The lasers 39, 19' may operate at different wavelengths and for example, the pumping radiation 37 produced by laser 39 may have a wavelength of 800nm whereas the output B of laser 19' may have a wavelength of 1550nm.

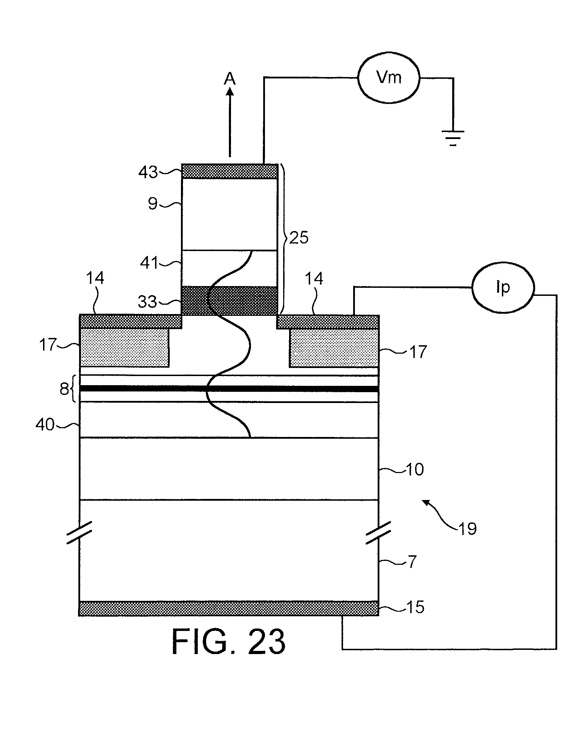

Figure 23 illustrates a modification in which a modulator 25 is integrated into the VCSEL 19 in order to encode information into the output pulse train produced by the laser. The structure of the laser 19 is based on the configuration described with reference to Figure 3 and the same reference numbers are used. The Bragg reflectors 9, 10 are however spaced further apart by the inclusion of spacer layers 40, 41, 42 so that a double lobe cavity is formed. The modulator 25 includes a layer 33 of saturable absorber which can be biased by an overlying electrode 42 with a modulating voltage $V_m$. The layers 33, 41 form a PN junction so that when the modulating voltage $V_m$ is applied, the resonance of the laser 19 is suppressed as a result its output, pulsed radiation A is modulated according to the pattern of the modulating voltage. It will be understood that the electrode 43 may be configured in the manner described with reference to Figure 12 (C or D) in order to provide an appropriate output port aperture 28 (not shown in Figure 23).

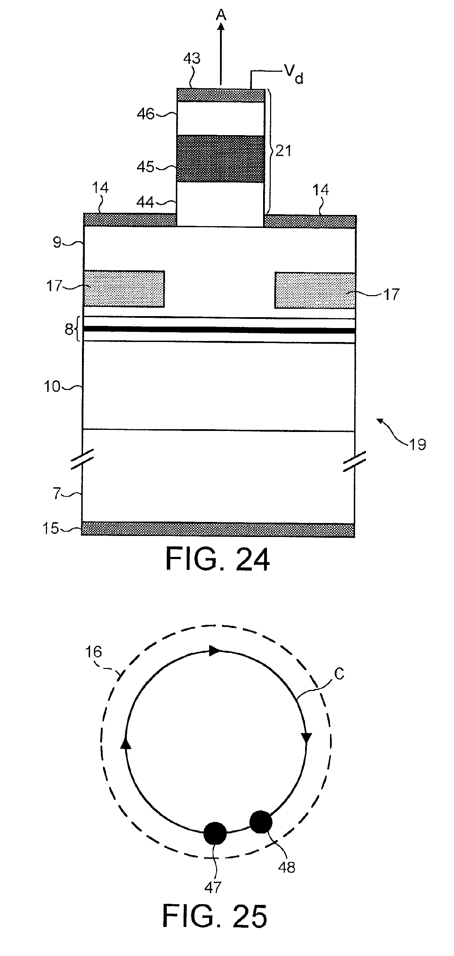

Figure 24 illustrates a modification in which the modulator 25 of Figure 23 is replaced by electrical detector 21. The detector 21 includes a spacer layer 44 together with an absorbing layer 45, which in combination provide a PN junction. As a result, a voltage $V_d$ is developed on electrode 43 to allow a clock signal corresponding to the pulsed optical output of the laser 19 to be developed. The optical output A passes through the electrode 43 as previously described.

Referring back to Figure 9, it will be understood that multiple outputs may be provided from the VCSEL 19 with a predetermined phase relationship between the pulses for the individual outputs. In order to ensure that the pulses are produced in a well defined sequence, the cavity 8 may be configured as shown in Figure 25, which is a schematic top view of the laser 19, looking into the aperture 16. In this configuration, the cavity 8 is overlaid by alternate regions of saturable absorber 47 and high gain regions 48 so that the pulse sequence follows the direction of arrow C.

Naturally present asymmetries in the laser structure due to processing can also be used to fix the pulse sequence and built into the laser structure as it is fabricated. The laser can then be suitably modulated by choosing the modulator biases to match the required pulse sequence output.

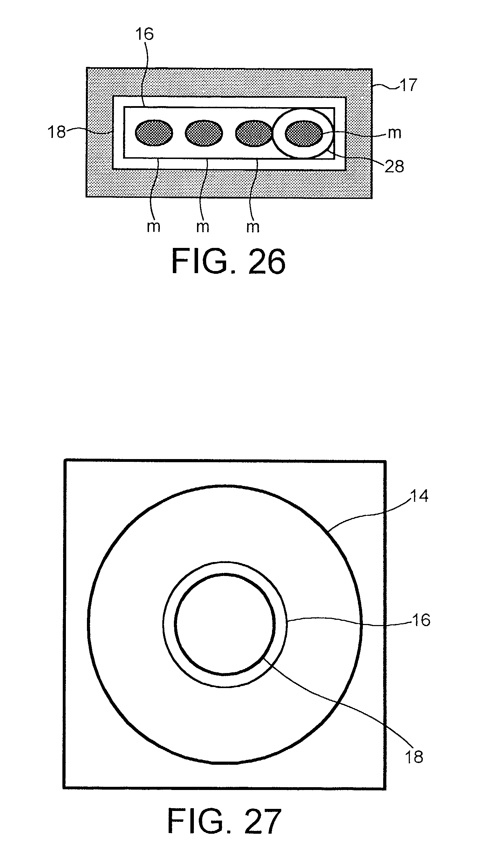

In the embodiments described so far, the cavity has a generally circular periphery. However, the requisite mode locking can be achieved in non-circular structures. Figure 26 illustrates an example of a linear geometry shown from above, in which the ion implanted region 17 defines a rectangular cavity. The top electrode 14 has an inner edge 16 which defines a substantially coextensive rectangular opening, in which output port 28 is provided in the manner previously described. With such a cavity, mode maxima $m$ are produced longitudinally of the cavity, with one of them coextensive with the output port 28 so that pulsed optical radiation is produced.

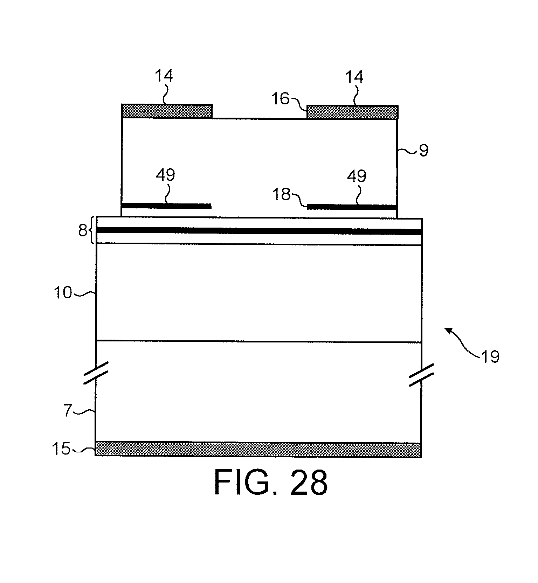

Many modifications and variations fall within the scope of the invention. For example, whilst in the described embodiments, the cavity is defined by an ion implantation region 17, other methods can be used to confine the cavity. For example, lateral oxidisation may be used. An example of such a configuration is illustrated in Figures 27 and 28. The structure of the laser is generally similar to the arrangement of Figure 3 but with the top Bragg reflector 9 configured as a mesa in which an aluminium oxide or oxidised AlGaAs layer 49 is included in the multiple layer structure that forms the reflector 9. The layer 49 defines the circular aperture 18 which confines current flowing between top and bottom contacts 14, 15 in a non-spatially uniform manner such as to promote mode locking.

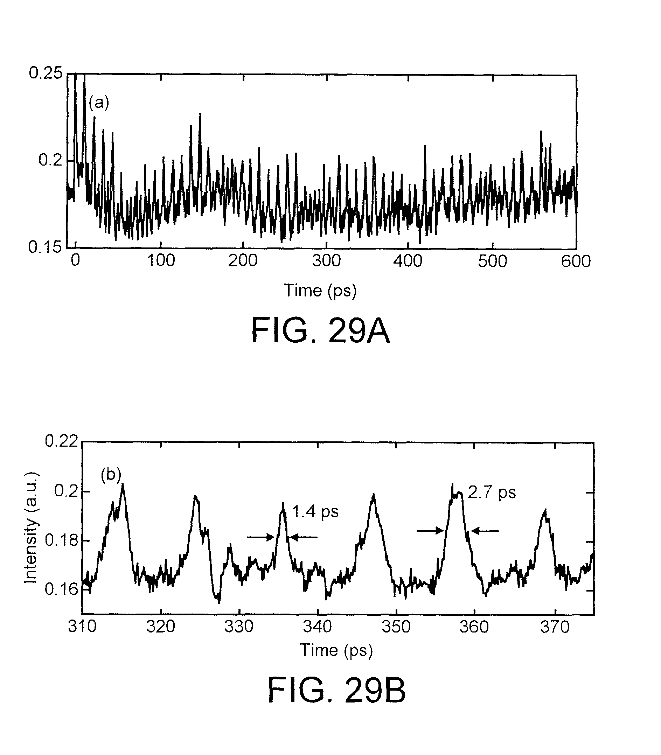

Figure 29 illustrates the optical output produced by a device according to the embodiment of Figures 2 and 3. Figure 29A illustrates the intensity of the pulsed optical output produced through output port 28 as a function of time from which it can be seen that a relatively low level of jitter occurs. Figure 29B is an enlarged portion of the trace of Figure 29A from which it can be seen that well defined picosecond scale pulses are produced in a regular pattern as a result of the lateral mode locking that occurs within the VCSEL.

Pulse generators according to the invention have many different commercial uses. For example, they can be used as femtosecond or picosecond pulse sources for telecommunications. They can also be used in optical computing, particularly for optical computer buses and have the advantage of avoiding coherence noise and timing jitter. It is also possible to achieve low levels of chirp. Also, with an appropriate choice of materials, the device can generate soliton pulses. Pulsed laser beams produced by the device according to the invention can also be used for imaging, radar, optical data reading devices and optical data writing devices.

## Claims

1.    An optical pulse generator comprising first and second reflective elements (9, 10) spaced apart by a relatively small thickness dimension, an optical resonant cavity (8) between the reflective elements that has a relatively large dimension in a direction transverse to the thickness dimension, the cavity being configured to resonate in a plurality of transverse modes which interact to produce mode locking whereby pulsed optical radiation is produced in transversely disposed regions of the cavity, and an optical port configuration (20, 24) to provide an output that comprises pulsed optical radiation emitted transversely of the cavity from one of the regions individually.

2. An optical pulse generator according to claim 1 including a layer of laser active material for producing optical radiation that is reflected in said plurality of modes between the first and second elements, for mode locked laser operation.

3. An optical pulse generator according to claim 2 including a pumping arrangement to pump the cavity into optical resonance.

4. An optical pulse generator according to claim 3 wherein the pumping arrangement is electrically driven and comprises electrodes for applying an energising current to the laser active material and produce optical resonance in the cavity in said plurality of transverse modes, whereby to produce the mode locking.

5. An optical pulse generator according to claim 4 wherein the cavity contains a material having an optical refractive index that is a function of applied electrical current, and the electrodes are configured to apply a non-uniform electrical current distribution to the cavity whereby to produce the optical resonance in said plurality of transverse modes.

6. An optical pulse generator according to claim 3 wherein the pumping arrangement is optically driven.

7. An optical pulse generator according to claim 6 wherein the pumping arrangement comprises a pumping laser to deliver pumping optical radiation into the cavity.

8. An optical pulse generator according to any preceding claim including a modulator to modulate optical resonance in the cavity and promote the mode locking actively.

9. An optical pulse generator according to claim 8 wherein the modulator is operable electrically to apply a modulating current to the cavity.

10. An optical pulse generator according to claim 8 wherein the modulator is operable optically to apply modulating optical radiation to the cavity.

11. An optical pulse generator according to any preceding claim including at least one absorptive region arranged to absorb selectively the resonant optical radiation from the cavity such as to promote the mode locking.

12. An optical pulse generator according to any preceding claim wherein the optical port configuration comprises an optical imaging system for imaging the optical radiation from said one of the regions onto a predetermined focus region.

13. An optical pulse generator according to any one of claims 1 to 12 wherein the optical port configuration comprises an optical waveguide for guiding the optical radiation from said one of the regions onto a predetermined focus region.

14. An optical pulse generator according to any one of claims 1 to 12 wherein the optical port configuration comprises an optically diffractive pattern for imaging the optical radiation from said one of the regions onto a predetermined focus region.

15. An optical pulse generator according to any preceding claim wherein at least one of the first and second reflective elements comprises a multiple layer configuration.

16. An optical pulse generator according to any preceding claim wherein the cavity has a generally circular periphery.

17. An optical pulse generator according to any one of claims 1 to 15 wherein the cavity has a generally rectangular periphery.

**18.** An optical pulse generator according to any preceding claim and comprising a VCSEL.

**19.** An optical pulse generator comprising a vertical cavity semiconductor laser operable with transverse mode locking and **characterised by** an output port configuration to receive light emitted in only a part of the cavity whereby to produce a pulsed optical output.

$$T_r = L_{eff}/C$$

FIG. 1

EP 1 317 035 A1

FIG. 2

FIG. 3

FIG. 4

FIG. 5

FIG. 6

FIG. 7

FIG. 8

FIG. 9

FIG. 10

FIG. 11

FIG. 12A

FIG. 12B

FIG. 12C

FIG. 13A

FIG. 13B

FIG. 13C

FIG. 13D

FIG. 14

FIG. 15A

31

32

9

8

10

# FIG. 15B

31

32

9

8

10

# FIG. 15C

FIG. 16

FIG. 17

FIG. 18

FIG. 19

FIG. 20

**FIG. 21**

**FIG. 22**

FIG. 23

FIG. 24

FIG. 25

FIG. 26

FIG. 27

FIG. 28

FIG. 29A

FIG. 29B

# EP 1 317 035 A1

**European Patent Office**

## EUROPEAN SEARCH REPORT

Application Number

EP 01 31 0006

## DOCUMENTS CONSIDERED TO BE RELEVANT

| Category | Citation of document with indication, where appropriate, of relevant passages | Relevant to claim | CLASSIFICATION OF THE APPLICATION (Int.Cl.7) |
|---|---|---|---|
| A | PATENT ABSTRACTS OF JAPAN vol. 016, no. 255 (E-1214), 10 June 1992 (1992-06-10) & JP 04 056293 A (MATSUSHITA ELECTRON CORP), 24 February 1992 (1992-02-24) * abstract * | 1 | H01S5/183 H01S5/42 H01S5/065 |
| A | KELLER U ET AL: "SEMICONDUCTOR SATURABLE ABSORBER MIRRORS(SESAM'S) FOR FEMTOSECOND TO NANOSECOND PULSE GENERATION IN SOLID-STATE LASERS" IEEE JOURNAL OF SELECTED TOPICS IN QUANTUM ELECTRONICS, IEEE SERVICE CENTER, US, vol. 2, no. 3, 1 September 1996 (1996-09-01), pages 435-451, XP000689812 ISSN: 1077-260X * the whole document * | 1 | |
| A | HOOGLAND S ET AL: "PASSIVELY MODE-LOCKED DIODE-PUMPED SURFACE-EMITTING SEMICONDUCTOR LASER" IEEE PHOTONICS TECHNOLOGY LETTERS, IEEE INC. NEW YORK, US, vol. 12, no. 9, September 2000 (2000-09), pages 1135-1137, XP000968623 ISSN: 1041-1135 * the whole document * | 1 | **TECHNICAL FIELDS SEARCHED (Int.Cl.7)** H01S |

-/--

The present search report has been drawn up for all claims

| Place of search | Date of completion of the search | Examiner |
|---|---|---|
| THE HAGUE | 5 November 2002 | Claessen, L |

EPO FORM 1503 03.82 (P04C01)

**European Patent Office**

**EUROPEAN SEARCH REPORT**

Application Number

EP 01 31 0006

## DOCUMENTS CONSIDERED TO BE RELEVANT

| Category | Citation of document with indication, where appropriate, of relevant passages | Relevant to claim | CLASSIFICATION OF THE APPLICATION (Int.Cl.7) |
|---|---|---|---|
| D,A | TAI K ET AL: "TRANSVERSE MODE EMISSION CHARACTERISTICS OF GAIN-GUIDED SURFACE EMITTING LASERS" APPLIED PHYSICS LETTERS, AMERICAN INSTITUTE OF PHYSICS. NEW YORK, US, vol. 63, no. 19, 8 November 1993 (1993-11-08), pages 2624-2626, XP000408669 ISSN: 0003-6951 * the whole document * | 1 | |

_____

TECHNICAL FIELDS
SEARCHED      (Int.Cl.7)

The present search report has been drawn up for all claims

| Place of search | Date of completion of the search | Examiner |
|---|---|---|
| THE HAGUE | 5 November 2002 | Claessen, L |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

**EP 1 317 035 A1**

## ANNEX TO THE EUROPEAN SEARCH REPORT
## ON EUROPEAN PATENT APPLICATION NO.

EP 01 31 0006

This annex lists the patent family members relating to the patent documents cited in the above-mentioned European search report.
The members are as contained in the European Patent Office EDP file on
The European Patent Office is in no way liable for these particulars which are merely given for the purpose of information.

05-11-2002

| Patent document cited in search report | Publication date | Patent family member(s) | Publication date |
|---|---|---|---|
| JP 04056293 A | 24-02-1992 | JP 2760451 B2 | 28-05-1998 |

EPO FORM P0459

For more details about this annex : see Official Journal of the European Patent Office, No. 12/82

29